# FASCICULE DE BREVET EUROPEEN

(11) **EP 3 652 845 B1**
(45) Date de publication et mention de la délivrance du brevet: **15.06.2022**
(21) Numéro de dépôt: 18752570.4
(22) Date de dépôt: 09.07.2018
(51) Int. Cl.: H02K 35/02

(54) **CONVERTISSEUR D'ENERGIE ELECTROMAGNETIQUE**
ELEKTROMAGNETISCHER ENERGIEWANDLER
ELECTROMAGNETIC ENERGY CONVERTER

(30) Priorité: 11.07.2017 FR 1756582
(43) Date de publication de la demande: 20.05.2020
(73) Titulaire: Commissariat à l'Énergie Atomique et aux Énergies Alternatives, 75015 Paris (FR)
(72) Inventeur: TOSONI, Olivier, 38100 Grenoble (FR); DELETTE, Gérard, 38100 Grenoble (FR)
(74) Mandataire: Brevalex
(86) Numéro de dépôt international: PCT/FR2018/051719
(87) Numéro de publication internationale: WO 2019/012213

(56) Documents cités:
- WO-A1-2009/119450
- CN-U- 204 408 156
- DE-A1- 19 852 470
- US-A- 4 471 353
- US-B2- 9 509 304

## Description

### DOMAINE TECHNIQUE

La présente invention concerne un convertisseur d'énergie électromagnétique. En particulier, la présente invention concerne un convertisseur d'énergie électromagnétique destiné à être mis en œuvre dans un interrupteur autonome.

### ART ANTÉRIEUR

Un convertisseur d'énergie électromagnétique, connu de l'état de la technique, comprend :
- une culasse ferromagnétique ;
- une bobine conductrice formée par l'enroulement d'un fil conducteur autour d'une section de la culasse ferromagnétique ;
- un aimant principal, déporté de la bobine, formant avec la culasse un circuit magnétique fermé.

Selon cette configuration, un flux magnétique généré par l'aimant principal et guidé par la culasse ferromagnétique traverse la bobine conductrice.

Le principe général de fonctionnement du convertisseur d'énergie électromagnétique est basé sur l'activation d'une variation temporelle du flux magnétique traversant la bobine conductrice de manière à faire apparaître une tension électrique aux bornes de cette dernière.

À cet égard, le convertisseur d'énergie électromagnétique est également doté d'un système d'activation mécanique dont l'action permet d'activer la variation temporelle de flux magnétique. En particulier, la variation temporelle de flux magnétique peut être due à un déplacement de l'aimant principal ou de la bobine conductrice, tel que décrit dans les documents [1] et [2] cités à la fin de la description.

Cependant, ces convertisseurs d'énergie électromagnétique décrits dans les documents [1] et [2] ne sont pas totalement satisfaisants.

En effet, le flux magnétique traversant la bobine conductrice est limité par les pertes magnétiques et la saturation magnétique de la culasse ferromagnétique, restreignant, par conséquent, la variation de flux magnétique utile à la génération de la tension électrique aux bornes de la bobine conductrice.

Par ailleurs, le système d'activation mécanique nécessite l'emploi d'un module d'échappement et/ou d'accumulation d'énergie, tels que des lames à ressort, ou encore des cliquets, permettant un mouvement rapide de la bobine conductrice ou de l'aimant principal de manière à ce qu'une tension appréciable puisse être atteinte aux bornes de la bobine conductrice.

A titre d'exemple, un déplacement d'une durée de l'ordre de la milliseconde est nécessaire pour un convertisseur, présentant un volume de l'ordre de 1 cm³, pour générer une tension électrique de l'ordre du Volt aux bornes de la bobine conductrice. Une tension de cet ordre de grandeur est notamment requise dès lors que le convertisseur d'énergie électromagnétique est mis en œuvre dans des interrupteurs autonomes.

Cependant, le module d'échappement et/ou d'accumulation d'énergie est généralement en contact avec le circuit magnétique générant ainsi de problèmes de fiabilité et d'usure.

Les documents DE19852470 et WO2009/119450 divulguent chacun un convertisseur d'énergie électromagnétique.

Un but de la présente invention est donc de proposer un convertisseur d'énergie électromagnétique compact, et susceptible de présenter une tension électrique appréciable aux bornes de la bobine conductrice.

Un autre but de la présente invention est également de proposer un convertisseur d'énergie électromagnétique plus simple à mettre œuvre.

### EXPOSÉ DE L'INVENTION

Les buts énoncés ci-dessus sont, au moins en partie, atteints par un convertisseur d'énergie électromagnétique comprenant :
- au moins une bobine conductrice d'axe principal XX',
- un aimant multipolaire monobloc comprenant au moins trois zones aimantées de mêmes dimensions, alignées selon un axe d'élongation YY' de l'aimant multipolaire, ledit aimant multipolaire étant agencé de sorte que les polarités magnétiques de deux zones aimantées contiguës soient orientées de manière essentiellement anti parallèle selon une direction perpendiculaire à l'axe d'élongation YY',
- une culasse ferromagnétique comprenant un cadre et un tronçon principal agencés de manière à former deux boucles magnétiques dites respectivement, première boucle magnétique et seconde boucle magnétique, contiguës au niveau du tronçon principal, le tronçon principal traverse l'au moins une bobine conductrice, la culasse comprend en outre un entrefer principal disposé sur le tronçon principal, et deux entrefers latéraux dits, respectivement, premier entrefer latéral et second entrefer latéral disposés sur le cadre,

l'entrefer principal, le premier entrefer latéral et le second entrefer latéral sont agencés pour former un organe de guidage dans lequel l'aimant multipolaire est inséré par coulissage, et de manière à permettre un couplage magnétique de trois zones aimantées successives avec, respectivement, le premier entrefer latéral, l'entrefer principal, et le second entrefer latéral.

Par « permettre le couplage magnétique d'une zone aimantée avec un entrefer », on entend que ladite zone aimantée impose la circulation d'un flux magnétique à partir de l'entrefer dans au moins une des deux boucles magnétiques. En d'autres termes, la zone aimantée est, au moins en partie, logée dans l'entrefer.

Selon un mode de mise en œuvre, l'aimant multipolaire comprend 4 zones aimantées.

Selon un mode de mise en œuvre, chacune des zones aimantées, parmi les au moins trois zones aimantées, comprend un aimant permanent, avantageusement les aimants permanents de chacune des zones aimantées sont identiques.

Selon un mode de mise en œuvre, le convertisseur comprend en outre un organe de rappel destiné à contraindre l'aimant multipolaire à adopter une première position d'équilibre magnétique dès lors qu'aucune force extérieure n'est exercée sur l'aimant multipolaire, plus particulièrement, la première position d'équilibre correspondant à une position de l'aimant multipolaire pour laquelle trois zones aimantées successives de l'aimant multipolaire et prédéterminées dites première zone aimantée, seconde zone aimantée, et troisième zone aimantée sont couplées magnétiquement avec, respectivement, le premier entrefer latéral, l'entrefer principal, et le second entrefer latéral, toujours plus particulièrement, la troisième zone aimantée étant disposée à une extrémité de l'aimant multipolaire.

Selon un mode de mise en œuvre, l'aimant multipolaire comprend 4 zones aimantées.

Selon un mode de mise en œuvre, l'au moins une bobine conductrice comprend deux bobines conductrices dites, respectivement, première bobine conductrice et seconde bobine conductrice, la première bobine conductrice et la seconde bobine conductrice étant chacune disposées de part et d'autre de l'entrefer principal, autour du tronçon central de la culasse ferromagnétique.

Selon un mode de mise en œuvre, le convertisseur est symétrique par rapport à un plan perpendiculaire à l'axe principal XX'.

Selon un mode de mise en œuvre, le cadre est un cadre rectangulaire qui comprend un premier tronçon latéral et un second tronçon latéral parallèles au tronçon principal et au niveau desquels sont disposés, respectivement, le premier entrefer latéral et le second entrefer latéral.

Selon un mode de mise en œuvre, les écartements du premier entrefer latéral, du second entrefer latéral et de l'entrefer principal sont égaux.

L'invention concerne également, un interrupteur comprenant un convertisseur selon la présente invention.

### BRÈVE DESCRIPTION DES DESSINS

D'autres caractéristiques et avantages apparaîtront dans la description qui va suivre du convertisseur d'énergie électromagnétique selon l'invention, donnés à titre d'exemples non limitatifs, en référence aux dessins annexés dans lesquels :
- les figures 1a et 1b sont des représentations schématiques, selon un plan de coupe comprenant les axes XX' et YY', d'un convertisseur d'énergie électromagnétique pourvu d'une seule bobine conductrice selon la présente invention ;
- les figures 2a et 2b sont des représentations schématiques, selon un plan de coupe comprenant les axes XX' et YY', d'un convertisseur d'énergie électromagnétique pourvu de deux bobines conductrices selon la présente invention.

### EXPOSÉ DÉTAILLÉ DE MODES DE RÉALISATION PARTICULIERS

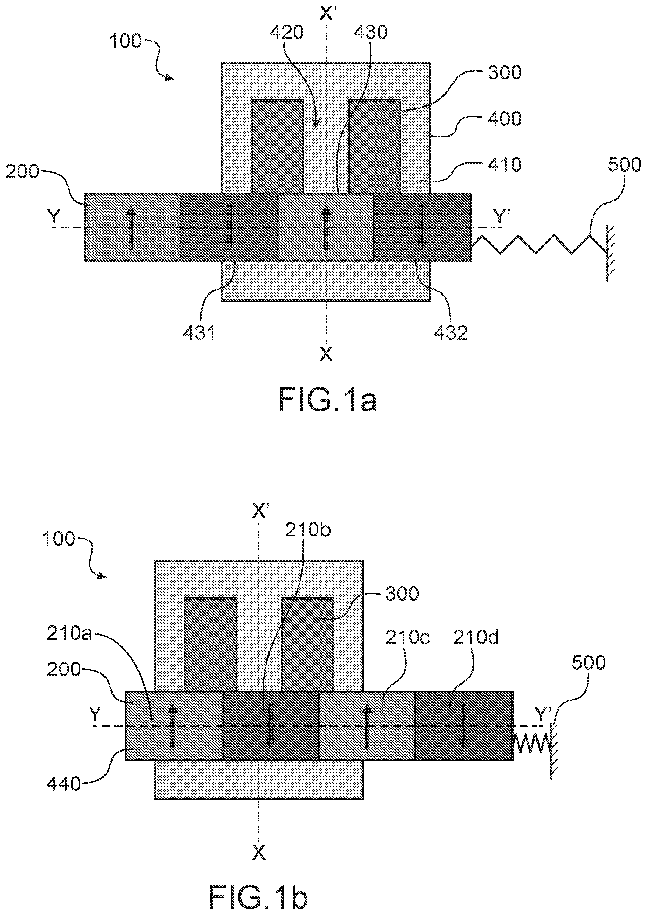

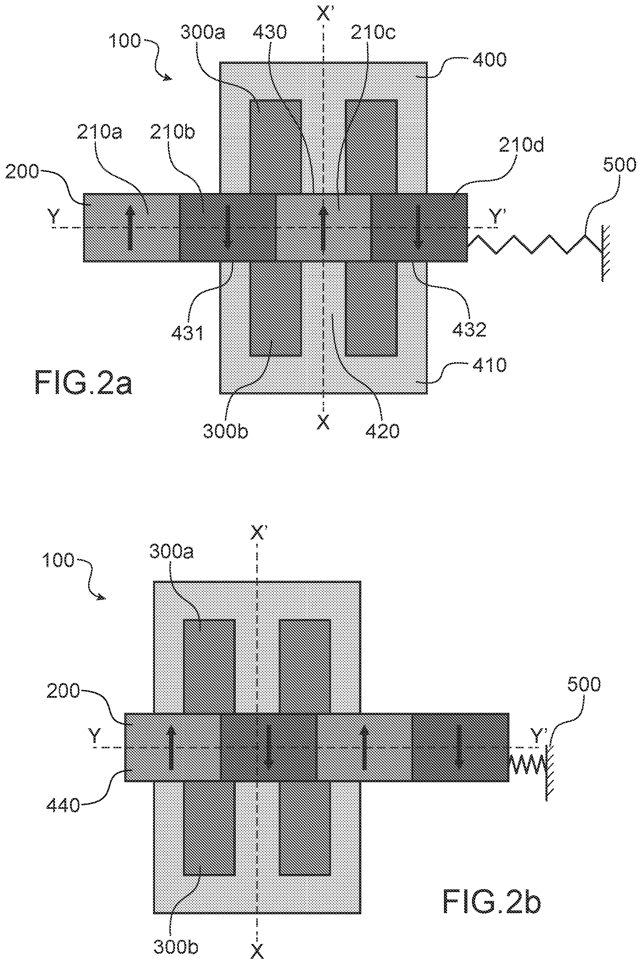

Sur les figures 1a, 1b, 2a et 2b on peut voir deux exemples de réalisation d'un convertisseur d'énergie électromagnétique 100 selon la présente invention.

Le convertisseur d'énergie électromagnétique 100 comprend un aimant multipolaire 200.

L'aimant multipolaire 200 est monobloc (figure 1a, et 2b), et comprend au moins trois zones aimantées 210a, 210b, 210c de mêmes dimensions et alignées selon un axe d'élongation YY' de l'aimant multipolaire. En particulier, les polarités magnétiques de deux zones aimantées contiguës sont orientées de manière essentiellement anti-parallèle selon une direction perpendiculaire à l'axe d'élongation YY'.

Par « polarisation magnétique », on entend l'orientation des pôles de l'aimant et la direction du champ magnétique créé par ledit aimant.

En d'autres termes, les polarisations magnétiques des au moins trois zones aimantées sont alternativement orientées selon des sens opposés (les polarisations magnétiques sont symbolisées par des flèches au niveau des zones aimantées aux figures la à 2b).

Il est entendu que dès lors que les zones aimantées 210a, 210b, et 210c ont les mêmes dimensions, l'agencement desdites zones aimantées, formant l'aimant multipolaire 200, est périodique de pas P selon l'axe d'élongation YY' dudit aimant multipolaire.

Il est également entendu, sans qu'il soit nécessaire de le préciser, que l'aimant multipolaire 200 est droit selon la direction définie par son axe d'élongation YY'. En particulier, l'aimant multipolaire 200 est un barreau, par exemple de forme parallélépipédique.

Les zones aimantées 210a, 210b, 210c et 2010d peuvent être de forme parallélépipédique.

Dans toute la suite de la description, un aimant multipolaire 200 comprenant 4 zones aimantées 210a, 210b, 210c et 210d sera considéré. Les raisonnements tenus dans ce contexte sont cependant transposables à tout aimant multipolaire 200 comprenant au moins 3 zones aimantées.

L'aimant multipolaire 200 peut comprendre un assemblage d'aimants permanents dont la dimension selon la direction d'élongation de l'aimant multipolaire 200 est égale au pas P.

Les aimants permanents sont avantageusement collés, ou encore sertis sur un support fait d'un matériau amagnétique, par exemple un matériau plastique.

Les aimants permanents peuvent comprendre au moins un des éléments choisis parmi : aimants NdFeB, aimants SmCo, aimants ferrites.

En particulier, les aimants permanents peuvent être frittés ou liés, anisotropes ou non.

L'invention n'est toutefois pas limitée à un aimant multipolaire 200 fait d'un assemblage d'aimants permanents, et peut présenter un profil magnétique (continu, ou non) périodique et présentant des aimantations maximale et minimale de signes opposés.

Le convertisseur d'énergie électromagnétique 100 comprend au moins une bobine conductrice 300 qui s'étend selon un axe principal XX' et comprend deux extrémités dites, respectivement, première extrémité et seconde extrémité (figures la et 1b).

Par « axe principal XX' », on entend un axe de symétrie de l'au moins une bobine conductrice 300.

L'au moins une bobine conductrice 300 est faite d'un enroulement d'un fil conducteur, par exemple un fil en cuivre, selon l'axe principal XX'. La bobine conductrice 300 comprend par ailleurs un volume interne V ouvert selon les deux extrémités de ladite bobine. Il est évident sans qu'il soit nécessaire de le préciser que le fil conducteur comprend deux extrémités qui sont, dans toute la suite de la présente description nommées bornes de la bobine conductrice 300.

Le convertisseur d'énergie électromagnétique 100 comprend, en outre, une culasse ferromagnétique 400.

La culasse ferromagnétique 400 comprend un cadre 410 et un tronçon principal 420.

La culasse ferromagnétique peut comprendre au moins un matériau ferromagnétique choisi parmi : les alliages à base de Fer et à forte induction à saturation ( par exemple une induction à saturation supérieure à 1,5 Tesla) tels que le Fer pur, le fer allié au Si (FeSi), le Fer allié au Ni (FeNi), le fer allié au Co (FeCo). Ces alliages peuvent également comprendre des éléments d'addition tels que le Cr, P, Cu, Al.

Le matériau ferromagnétique peut également comprendre au moins un des éléments choisi parmi : une ferrite de structure spinelle ( telle que MnZn, NiZn). Ces dernières, du fait de leur faible conductivité électrique, sont particulièrement avantageuses car elles permettent de diminuer les pertes par courant de Foucault.

Enfin, le matériau ferromagnétique peut également comprendre au moins un des éléments choisi parmi : un alliage à base de Fe de type verre métallique élaboré sous forme amorphe ou nanocristalline.

Ces matériaux peuvent être massifs ou bien, plus avantageusement, sous la forme de tôles empilées et séparées par de minces films isolants (à l'exception des matériaux ferrites doux) dans le but de limiter les courants induits et les pertes associées.

Au sens de la présente invention, le cadre 410 n'est pas nécessairement monobloc.

Le cadre 410 et le tronçon principal 420 sont agencés de manière à former deux boucles magnétiques dites, respectivement, première boucle magnétique et seconde boucle magnétique, contiguës au niveau du tronçon principal 420. En d'autres termes, le cadre 410 et le tronçon principal 420 sont agencés pour guider un flux magnétique selon deux boucles magnétiques.

L'aire de la section transversale du tronçon principale 420 peut être le double de l'aire de la section transversale du cadre 410.

Par « contiguës au niveau du tronçon principal », on entend que les deux boucles magnétiques passent par le tronçon principal 420.

Le tronçon principal 420 traverse l'au moins une bobine conductrice 300 selon l'axe principal XX', de sorte que tout flux magnétique guidé par l'une et/ou l'autre des deux boucles magnétiques traverse également l'au moins une bobine conductrice 300.

Il est également entendu, au sens de la présente invention, que le terme « tronçon » désigne un élément droit (par exemple, une barre, un barreau) s'étendant selon un axe d'élongation. Cette définition ne limite en rien la forme de sa section transversale (la section transversale désignant un plan de coupe du tronçon selon un plan perpendiculaire à l'axe d'élongation dudit tronçon).

La culasse ferromagnétique 400 comprend un entrefer principal 430 (« air gap » selon la terminologie Anglo-Saxonne), et deux entrefers latéraux dits, respectivement, premier entrefer latéral 431 et second entrefer latéral 432 (figures la et 2a).

L'entrefer principal 430 est disposé au niveau du tronçon principal 420.

Le premier entrefer latéral 431 et le second entrefer latéral 432 sont disposés sur le cadre 410.

L'entrefer principal 430, le premier entrefer latéral 431 et le second entrefer latéral 432 sont agencés pour former un organe de guidage 440 dans lequel l'aimant multipolaire 200 est inséré en coulissage (figures 1b et 2b).

Par « inséré en coulissage », on entend que l'aimant multipolaire 200 peut coulisser, par exemple, sous l'action d'une force extérieure.

En particulier, l'aimant multipolaire 200 étant rectiligne, il est entendu que l'entrefer principal 430, le premier entrefer latéral 431 et le second entrefer latéral 432 sont alignés selon l'axe d'élongation YY' de l'aimant multipolaire 200.

Il est également entendu sans qu'il soit nécessaire de le préciser, que le premier entrefer 431 et le second entrefer 432 sont disposés, respectivement, sur la première boucle magnétique et sur la seconde boucle magnétique.

En outre, l'entrefer principal 430, le premier entrefer latéral 431 et le second entrefer latéral 432 sont agencés de manière à permettre un couplage magnétique, de manière simultanée, de trois zones aimantées successives avec, respectivement, le premier entrefer latéral, l'entrefer principal, et le second entrefer latéral.

Par « permettre le couplage magnétique d'une zone aimantée avec un entrefer », on entend que ladite zone aimantée impose la circulation d'un flux magnétique à partir de l'entrefer dans au moins une des deux boucles magnétiques. En d'autres termes, la zone aimantée est, au moins en partie, logée dans l'entrefer.

En particulier, l'entrefer principal 430, le premier entrefer latéral 431 et le second entrefer latéral 432 peuvent être agencés de manière à permettre un centrage selon l'axe d'élongation YY' de trois zones aimantées successives dans, respectivement, le premier entrefer latéral 431, l'entrefer principal 430, et le second entrefer latéral 432.

Il est alors entendu que l'entrefer principal est équidistant des premier et second entrefers latéraux.

En particulier, une zone aimantée couplée avec le premier entrefer latéral 431 impose la circulation d'un flux magnétique le long de la première boucle magnétique, et selon un sens déterminé par l'orientation de la polarisation magnétique de ladite zone aimantée.

De manière équivalente, une zone aimantée couplée avec le second entrefer latéral impose la circulation d'un flux magnétique le long de la seconde boucle magnétique, et selon un sens déterminé par l'orientation de la polarisation magnétique de ladite zone aimantée.

Enfin, une zone aimantée couplée avec l'entrefer principal impose la circulation d'un flux magnétique le long de la première et de la seconde boucle magnétique, et selon un sens déterminé par l'orientation de la polarisation magnétique de ladite zone aimantée.

Ainsi, l'agencement périodique de l'aimant multipolaire 200 permet aux flux magnétiques des trois zones aimantées de s'ajouter et de converger dans le tronçon principal 420, de manière à traverser l'au moins une bobine conductrice 300.

Par ailleurs, dès lors que des zones aimantées successives de l'aimant multipolaire 200 sont magnétiquement couplées à des entrefers de la culasse ferromagnétique 400 (par exemple 3 zones aimantées sont couplées, respectivement, aux trois entrefers), le convertisseur d'énergie électromagnétique 100 se trouve dans un état d'équilibre magnétique stable.

Dès lors qu'il se trouve dans un état d'équilibre magnétique stable, l'aimant multipolaire 200 offre une résistance à tout coulissage selon l'axe d'élongation YY'.

Cependant, dès lors que le coulissage de l'aimant multipolaire 200 selon l'axe d'élongation YY', sous l'action d'une force extérieure, dépasse un demi pas P à partir d'une position d'équilibre stable initiale, ledit aimant multipolaire subit une force magnétique attractive le contraignant à adopter une nouvelle position d'équilibre stable.

Cette nouvelle position d'équilibre stable correspond à une translation d'un pas P de l'aimant multipolaire 200 par rapport à la position d'équilibre stable initiale.

En particulier, dépendamment du sens de la force exercée sur l'aimant multipolaire 200, dès lors que ce dernier comprend quatre zones aimantées, la nouvelle position d'équilibre stable correspond au couplage de trois zones entrefers avec trois zones aimantées.

Lors du coulissage de l'aimant multipolaire 200 sous l'action de la force extérieure, la transition de ce dernier de la position d'équilibre stable initiale vers la nouvelle position d'équilibre stable génère une variation de flux magnétique (en particulier une inversion du flux magnétique) traversant l'au moins une bobine conductrice 300. De cette variation de flux magnétique résulte l'apparition d'une tension électrique aux bornes de l'au moins une bobine conductrice 300. Il est par ailleurs notable que la force magnétique attractive s'exerçant sur l'aimant multipolaire 200 lors de son coulissage accélère le mouvement, et favorise ainsi une variation rapide du flux magnétique traversant l'au moins une bobine conductrice 300. A titre d'exemple, un aimant multipolaire dont la masse est de l'ordre de 1 gramme peut coulisser entre deux positions d'équilibre magnétique stables en quelques millisecondes. Cette transition rapide est favorable à la génération d'une tension électrique appréciable, par exemple de l'ordre du volt, aux bornes de la bobine conductrice 300.

De manière avantageuse, le convertisseur d'énergie électromagnétique 100 peut comprendre un organe de rappel 500 destiné à contraindre l'aimant multipolaire à adopter une première position d'équilibre magnétique stable P1 dès lors qu'aucune force extérieure n'est exercée sur l'aimant multipolaire.

La première position d'équilibre magnétique stable P1 (figures la et 2a) peut alors correspondre à une position de l'aimant multipolaire 200 pour laquelle trois zones aimantées successives et prédéterminées dites première zone aimantée, seconde zone aimantée et troisième zone aimantée sont couplées magnétiquement avec, respectivement, le premier entrefer latéral 431, l'entrefer principal 430, et le second entrefer latéral 432.

Selon cet agencement, pour lequel sont considérés quatre zones aimantées et un organe de rappel 500, une force exercée sur l'aimant multipolaire provoquera son coulissage de la première position d'équilibre magnétique stable P1 vers une autre position d'équilibre magnétique (ce coulissage est aussi appelé « cycle direct »), tandis que l'organe de rappel 500, après relâchement de la force, rétablira l'aimant multipolaire dans sa première position d'équilibre magnétique stable P1 (ce coulissage inverse est aussi appelé « cycle indirect »). Ce coulissement dit aller/retour de l'aimant multipolaire 200 permet d'augmenter la variation de flux magnétique traversant l'au moins une bobine conductrice 300.

Ainsi, selon la présente invention, le guidage de l'aimant multipolaire 200 est réalisé par les entrefers permet de considérer un convertisseur d'énergie électromagnétique compact.

Par ailleurs, un simple coulissage de l'aimant multipolaire permet de réaliser une inversion de flux au niveau chacun des entrefers pour un déplacement de « un pas P » selon l'axe d'élongation dudit aimant multipolaire.

En outre, la bistabilité du convertisseur d'énergie électromagnétique 100 au sens de la présente invention permet de se passer complètement d'un module d'échappement et/ou d'accumulation d'énergie.

De manière particulièrement avantageuse, l'aimant multipolaire peut comprendre 5 zones aimantées. L'augmentation du nombre de zones aimantées permet d'obtenir plusieurs inversions du flux magnétique traversant l'au moins un bobine conductrice 300.

L'au moins une bobine conductrice 300 peut comprendre deux bobines conductrice dites, respectivement, première bobine conductrice 300a et seconde bobine conductrice 300b (figure 2a et 2b).

En particulier, la première bobine conductrice 300a et la seconde bobine conductrice 300b sont chacune disposées de part et d'autre de l'entrefer principal 430.

Le convertisseur d'énergie électromagnétique 100 peut également être symétrique par rapport à un plan perpendiculaire à l'axe principal XX'.

De manière avantageuse, le cadre 410 peut être un cadre rectangulaire qui comprend un premier tronçon latéral et un second tronçon latéral parallèles au tronçon principal et au niveau desquels sont disposés, respectivement, le premier entrefer latéral 431 et le second entrefer latéral 432.

La culasse ferromagnétique peut avantageusement être un assemblage de deux « sous-classes » ferromagnétiques en forme de « E ».

Par ailleurs, les écartements du premier entrefer latéral 431, du second entrefer latéral 432 et de l'entrefer principal 430 peuvent être égaux.

En particulier, l'axe principal du tronçon principal est à une distance P de chacun des axes principaux des premier et second tronçons latéraux.

L'aimant multipolaire 200 peut être produit en juxtaposant plusieurs aimants permanents uniaxiaux et en respectant une alternance de leur polarité. Les aimants permanents peuvent être collés entre eux, ou sertis sur un support fait d'un matériau amagnétique et peu conducteur comme le plastique. Les aimants permanents peuvent avantageusement être des aimants frittés. Ces derniers présentent l'avantage d'avoir une rémanence élevée, et donc de générer un flux magnétique par unité de volume plus important.

De manière alternative, l'aimant multipolaire peut être formé par moulage par injection plastique d'un mélange chaud dans la cavité d'un moule. Par exemple, le mélange chaud injecté peut comprendre un ou des polymères et une poudre magnétique (par exemple une poudre de SmCo ou de NdFeB convenablement traitée). Un champ magnétique est généré dans la cavité du moule par un système magnétique spécifique logé dans le moule d'injection. Ce champ présente l'alternance N-S / S-N selon la périodicité visée dans l'aimant multipolaire.

Lorsque les particules de poudre magnétique parviennent dans l'empreinte, elles ont le temps de s'orienter et de s'aimanter en suivant ce champ avant que le polymère ne se fige par refroidissement. Une fois bloquées par le polymère froid, les particules magnétiques conservent l'aimantation imprimée par le moule et reproduisent le profil magnétique périodique magnétique désiré.

La présente invention concerne également un interrupteur, par exemple un interrupteur autonome comprenant le convertisseur d'énergie électromagnétique selon la présente invention.

La mise en œuvre d'un convertisseur d'énergie électromagnétique selon la présente invention permet de réaliser des interrupteurs autonomes de petite taille et plus robuste par rapport aux interrupteurs connus de l'état de la technique.

Le convertisseur d'énergie électromagnétique peut également être mis en œuvre dans des commandes, des capteurs de fin de course, des détecteurs d'ouverture, et autres détecteurs autonomes actionnés mécaniquement.

Dans la plupart des cas, l'énergie récupérée servira en partie à transmettre une information radio à un récepteur sans-fil distant, information donnant par exemple l'état des interrupteurs/capteurs/détecteurs. Toutefois, d'autres applications sont envisageables, tel que par exemple le comptage d'événements, avec un enregistrement dans une mémoire et qui ne communique pas forcément à chaque pression mécanique.

### RÉFÉRENCES

[1] US9240267,
[2] US9509304.

## Revendications

1. Convertisseur d'énergie électromagnétique (100) comprenant :
- au moins une bobine conductrice (300) d'axe principal XX',
- un aimant multipolaire (200) comprenant au moins trois zones aimantées (210a, 210b, 210c) de mêmes dimensions, alignées selon un axe d'élongation YY' de l'aimant multipolaire (200), ledit aimant multipolaire (200) étant agencé de sorte que les polarités magnétiques de deux zones aimantées contiguës soient orientées de manière essentiellement anti-parallèle selon une direction perpendiculaire à l'axe d'élongation YY',
- une culasse ferromagnétique (400) comprenant un cadre (410) et un tronçon principal (420) agencés de manière à former deux boucles magnétiques dites respectivement, première boucle magnétique et seconde boucle magnétique, contiguës au niveau du tronçon principal (420), le tronçon principal (420) traverse l'au moins une bobine conductrice (300), la culasse comprend en outre un entrefer principal (430) disposé sur le tronçon principal (420), et deux entrefers latéraux dits, respectivement, premier entrefer latéral (431) et second entrefer latéral (432) disposés sur le cadre (410),
Le convertisseur est **caractérisé en ce que** l'aimant multipolaire est monobloc et **en ce que** l'entrefer principal (430), le premier entrefer latéral (431) et le second entrefer latéral (432) sont agencés pour former un organe de guidage dans lequel l'aimant multipolaire (200) est inséré par coulissage, et de manière à permettre un couplage magnétique de trois zones aimantées successives avec, respectivement, le premier entrefer latéral (431), l'entrefer principal (430), et le second entrefer latéral (432).

2. Convertisseur selon la revendication 1, dans lequel chacune des zones aimantées, parmi les au moins trois zones aimantées (210a, 210b, 210c), comprend un aimant permanent, avantageusement, les aimants permanents de chacune des zones aimantées sont identiques.

3. Convertisseur selon la revendication 1 ou 2, dans lequel le convertisseur comprend en outre un organe de rappel (440) destiné à contraindre l'aimant multipolaire (200) à adopter une première position d'équilibre magnétique stable P1 dès lors qu'aucune force extérieure n'est exercée sur l'aimant multipolaire (200), plus particulièrement, la première position d'équilibre magnétique stable P1 correspondant à une position de l'aimant multipolaire (200) pour laquelle trois zones aimantées successives et prédéterminées dites première zone aimantée, seconde zone aimantée et troisième zone aimantée sont couplées magnétiquement avec, respectivement, le premier entrefer latéral (431), l'entrefer principal (430), et le second entrefer latéral (432), toujours plus particulièrement, la troisième zone aimantée étant disposée selon une extrémité de l'aimant multipolaire (200).

4. Convertisseur selon l'une des revendications 1 à 3, dans lequel l'aimant multipolaire (200) comprend 4, avantageusement 5, zones aimantées.

5. Convertisseur selon l'une des revendications 1 à 4, dans lequel l'au moins une bobine conductrice (300) comprend deux bobines conductrices dites, respectivement, première bobine conductrice (300a) et seconde bobine conductrice (300b), la première bobine conductrice (300a) et la seconde bobine conductrice (300b) étant chacune disposées de part et d'autre de l'entrefer principal (430).

6. Convertisseur selon la revendication 5, dans lequel le convertisseur est symétrique par rapport à un plan perpendiculaire à l'axe principal XX'.

7. Convertisseur selon l'une des revendications 1 à 6, dans lequel le cadre (410) est un cadre rectangulaire qui comprend un premier tronçon latéral et un second tronçon latéral parallèles au tronçon principal (420) et au niveau desquels sont disposés, respectivement, le premier entrefer latéral (431) et le second entrefer latéral (432).

8. Convertisseur selon l'une des revendications 1 à 7, dans lequel les écartements du premier entrefer latéral (431), du second entrefer latéral (432) et de l'entrefer principal (430) sont égaux.

9. Interrupteur comprenant un convertisseur selon l'une des revendications 1 à 8.

## Patentansprüche

1. Elektromagnetischer Energiewandler (100), enthaltend:
- zumindest eine leitende Spule (300) mit einer Hauptachse XX',
- einen mehrpoligen Magneten (200) mit zumindest drei magnetisierten Bereichen (210a, 210b, 210c) gleicher Abmessungen, die entlang einer Längsachse YY' des mehrpoligen Magneten (200) fluchten, wobei der mehrpolige Magnet (200) so angeordnet ist, dass die magnetischen Polaritäten von zwei aneinandergrenzenden magnetisierten Bereichen im Wesentlichen antiparallel in einer Richtung senkrecht zur Längsachse YY' ausgerichtet sind,
- ein ferromagnetisches Joch (400) mit einem Rahmen (410) und einem Hauptabschnitt (420), die so angeordnet sind, dass sie zwei magnetische Schleifen bilden, erste magnetische Schleife bzw. zweite magnetische Schleife genannt, die an dem Hauptabschnitt (420) aneinandergrenzen, wobei der Hauptabschnitt (420) durch die zumindest eine leitende Spule (300) verläuft, wobei das Joch ferner einen an dem Hauptabschnitt (420) angeordneten Hauptluftspalt (430) und zwei an dem Rahmen (410) angeordnete seitliche Luftspalte, erster seitlicher Luftspalt (431) bzw. zweiter seitlicher Luftspalt (432) genannt, umfasst,
wobei der Wandler **dadurch gekennzeichnet ist, dass** der mehrpolige Magnet einteilig ausgeführt ist und dass der Hauptluftspalt (430), der erste seitliche Luftspalt (431) und der zweite seitliche Luftspalt (432) so angeordnet sind, dass sie ein Führungsorgan bilden, in das der mehrpolige Magnet (200) gleitend eingesetzt ist, und eine magnetische Kopplung von drei aufeinanderfolgenden magnetisierten Bereichen mit dem ersten seitlichen Luftspalt (431), dem Hauptluftspalt (430) bzw. dem zweiten seitlichen Luftspalt (432) gestatten.

2. Wandler nach Anspruch 1, wobei jeder der magnetisierten Bereiche aus den zumindest drei magnetisierten Bereichen (210a, 210b, 210c) einen Permanentmagneten umfasst, wobei vorteilhafterweise die Permanentmagneten jedes der magnetisierten Bereiche identisch sind.

3. Wandler nach Anspruch 1 oder 2, wobei der Wandler ferner ein Rückstellglied (440) umfasst, um den mehrpoligen Magneten (200) zu veranlassen, eine erste stabile magnetische Gleichgewichtsposition P1 einzunehmen, sobald keine Kraft von außen auf den mehrpoligen Magneten (200) ausgeübt wird, wobei insbesondere die erste stabile magnetische Gleichgewichtsposition P1 einer Position des mehrpoligen Magneten (200) entspricht, bei der drei aufeinanderfolgende vorbestimmte magnetisierte Bereiche, erster magnetisierter Bereich, zweiter magnetisierter Bereich und dritter magnetisierter Bereich genannt, magnetisch mit dem ersten seitlichen Luftspalt (431), dem Hauptluftspalt (430) bzw. dem zweiten seitlichen Luftspalt (432) gekoppelt sind, wobei insbesondere der dritte magnetisierte Bereich entlang eines Endabschnitts des mehrpoligen Magneten (200) angeordnet ist.

4. Wandler nach einem der Ansprüche 1 bis 3, wobei der mehrpolige Magnet (200) 4, vorteilhafterweise 5, magnetisierte Bereiche umfasst.

5. Wandler nach einem der Ansprüche 1 bis 4, wobei die zumindest eine leitende Spule (300) zwei leitende Spulen, erste leitende Spule (300a) und zweite leitende Spule (300b) genannt, umfasst, wobei die erste leitende Spule (300a) und die zweite leitende Spule (300b) auf den beiden jeweiligen Seiten des Hauptluftspalts (430) angeordnet sind.

6. Wandler nach Anspruch 5, wobei der Wandler in Bezug auf eine Ebene senkrecht zur Hauptachse XX' symmetrisch ist.

7. Wandler nach einem der Ansprüche 1 bis 6, wobei der Rahmen (410) ein rechteckigförmiger Rahmen ist, der einen ersten Seitenabschnitt und einen zweiten Seitenabschnitt umfasst, die parallel zum Hauptabschnitt (420) verlaufen und an denen der erste seitliche Luftspalt (431) bzw. der zweite seitliche Luftspalt (432) angeordnet sind.

8. Wandler nach einem der Ansprüche 1 bis 7, wobei die Abstände des ersten seitlichen Luftspalts (431), des zweiten seitlichen Luftspalts (432) und des Hauptluftspalts (430) gleich sind.

9. Schalter mit einem Wandler nach einem der Ansprüche 1 bis 8.

## Claims

1. Electromagnetic energy converter (100) comprising:
- at least one conductive coil (300) of main axis XX',
- a multipole magnet (200) comprising at least three magnetised zones (210a, 210b, 210c) of the same dimensions, aligned along an elongation axis YY' of the multipole magnet (200), said multipole magnet (200) being arranged in such a way that the magnetic polarities of two adjacent magnetised zones are essentially oriented so that they are anti-parallel in a direction perpendicular to the elongation axis YY',
- a ferromagnetic yoke (400) comprising a frame (410) and a main section (420) arranged so as to form two magnetic loops respectively referred to as a first magnetic loop and a second magnetic loop, which are adjacent at the main section (420), the main section (420) passes through the at least one conductive coil (300), the yoke further comprises a main air-gap (430) disposed on the main section (420), and two lateral air-gaps, respectively referred to as a first lateral air-gap (431) and a second lateral air-gap (432) which are disposed on the frame (410), the main air-gap (430),
the converter is **characterised in that** the multipole magnet (200) is a single piece and **in that** the main air-gap (430), the first lateral air-gap (431) and the second lateral air-gap (432) are arranged in such a way as to form a guide member into which the multipole magnet (200) is inserted by sliding, and in such a way as to allow magnetic coupling of three successive magnetised zones with, respectively, the first lateral air-gap (431), the main air-gap (430), and the second lateral air-gap (432).

2. Converter according to claim 1, wherein each of the magnetised zones from the at least three magnetised zones (210a, 210b, 210c) comprises a permanent magnet, and advantageously the permanent magnets of each of the magnetised zones are identical.

3. Converter according to claim 1 or 2, wherein the converter further comprises a return member (440) intended to force the multipole magnet (200) to adopt a first stable position of magnetic equilibrium P1 when no external force is exerted on the multipole magnet (200), more particularly, the first stable position of magnetic equilibrium P1 corresponding to a position of the multipole magnet (200) for which three successive and predetermined magnetised zones, referred to as a first magnetised zone, a second magnetised zone and a third magnetised zone are magnetically coupled with, respectively, the first lateral air-gap (431), the main air-gap (430) and the second lateral air-gap (432), more particularly, the third magnetised zone being disposed at one end of the multipole magnet (200).

4. Converter according to one of claims 1 to 3, wherein the multipole magnet (200) comprises 4, or advantageously 5, magnetised zones.

5. Converter according to one of claims 1 to 4, wherein the at least one conductive coil (300) comprises two conductive coils, respectively referred to as a first conductive coil (300a) and a second conductive coil (300b), the first conductive coil (300a) and the second conductive coil (300b) each being disposed on either side of the main air-gap (430).

6. Converter according to claim 5, wherein the converter is symmetric relative to a plane perpendicular to the main axis XX'.

7. Converter according to one of claims 1 to 6, wherein the frame (410) is a rectangular frame which comprises a first lateral section and a second lateral section parallel to the main section (420) and at which the first lateral air-gap (431) and the second lateral air-gap (432) are respectively disposed.

8. Converter according to one of claims 1 to 7, wherein the gaps of the first lateral air-gap (431), the second lateral air-gap (432) and the main air-gap (430) are equal.

9. Switch comprising a converter according to one of claims 1 to 8.
